(19) Europäisches Patentamt
European Patent Office
Office européen des brevets

(11) **EP 1 909 315 A1**

(12) **EUROPEAN PATENT APPLICATION**
published in accordance with Art. 153(4) EPC

(43) Date of publication:
**09.04.2008 Bulletin 2008/15**

(51) Int Cl.:
*H01L 21/322* (2006.01)    *H01L 21/324* (2006.01)
*H01L 21/26* (2006.01)    *C30B 29/06* (2006.01)
*C30B 33/02* (2006.01)

(21) Application number: **05806093.0**

(22) Date of filing: **09.11.2005**

(86) International application number:
**PCT/JP2005/020548**

(87) International publication number:
**WO 2007/013189 (01.02.2007 Gazette 2007/05)**

(84) Designated Contracting States:
**DE**

(30) Priority: **27.07.2005 JP 2005217647**

(71) Applicant: **SUMCO Corporation**
**Tokyo 105-8634 (JP)**

(72) Inventors:
• **SUGIMURA, Wataru,**
**c/o SUMCO CORPORATION**
**Tokyo 1058634 (JP)**

• **ONO, Toshiaki,**
**c/o SUMCO CORPORATION**
**Tokyo 1058634 (JP)**
• **HOURAI, Masataka,**
**c/o SUMCO CORPORATION**
**Tokyo 1058634 (JP)**

(74) Representative: **Albrecht, Thomas**
**Kraus & Weisert**
**Patent- und Rechtsanwälte**
**Thomas-Wimmer-Ring 15**
**D-80539 München (DE)**

(54) **SILICON WAFER AND PROCESS FOR PRODUCING THE SAME**

(57)    A silicon single crystal is grown by the Czochralski method in an inert atmosphere that includes a gaseous substance containing hydrogen atoms. Wafers obtained from the resulting silicon single crystal are subjected to high temperature heat treatment in a non-oxidizing atmosphere at a temperature of not lower than 1000°C but not more than 1300°C. The high temperature heat treatment step is preceded by low temperature heat treatment at a lower temperature.

FIG. 13

## Description

TECHNICAL FIELD

The present invention relates to a silicon wafer and a method for producing the same, particularly relates to a method for producing a silicon wafer sliced from a silicon single-crystal ingot grown by the Czochralski method. The invention relates to a technique suitable for use in suppressing slip dislocations and improving wafer strength.

Priority is claimed on Japanese Patent Application No. 2005-217647, filed July 27, 2005, the contents of which are incorporated herein by reference.

BACKGROUND ART

A single crystalline silicon wafer capable of being used as a substrate for semiconductor device and the like are produced by slicing a silicon single-crystal ingot and carrying out operations such as heat treatment and mirror polishing. Silicon single-crystal ingot production processes are exemplified by the Czochralski (CZ) method. By the CZ method, single crystalline ingots of a large diameter are easily provided, and occurrence of defects is relatively easily controlled. Because of such advantages, the CZ method is widely used to produce single crystals.

In the production of a silicon single crystal by the CZ method, the crystal is grown using a quartz crucible. Therefore, oxygen is included within the crystal in a supersaturated state. Such oxygen generates thermal donors (TDs), for example, during the heat treatment steps for forming circuit in the device, and cause a problem of unstable fluctuation of resistivity of the wafer during the device production process.

In conventional low-resistance wafers doped with a dopant, thermal donors have a minimal influence on the wafer resistivity and thus do not cause a problem in actual operation. However, in the case of high-resistance wafers containing a limited amount of dopant, the resistivity of an n-type wafer drops off sharply with increasing thermal donors. In the case of a p-type wafer, the resistivity increases abruptly at first with increasing thermal donors. While the further increase of thermal donors changes the wafer from p-type to n-type and sharply decreases the resistivity.

Silicon wafers are generally subjected to donor killer (DK) treatment so as to prevent fluctuation of resistivity on account of thermal donors. Silicon wafers subjected to hydrogen annealing or argon annealing are also subjected to donor killer treatment prior to the high temperature annealing treatment to inhibit fluctuation of resistivity. Thermal donors are the factors for promoting the precipitation of oxide as well as fluctuating the resistivity.

A silicon single crystal that has been pulled by the CZ method interstitially takes up oxygen to a supersaturated state. The supersaturated oxygen causes microdefects known as bulk microdefects (BMDs) to occur during annealing, for example, in a wafer processing operation. In a formation process of semiconductor device on a single crystalline silicon wafer, the device-forming region is desired to have no crystal defects. If crystal defects occur in the wafer surface on which a circuit is to be formed, such defective area causes failure of the circuits or the like.

BMDs have a effect of gettering metal impurities or the like. Such impurities cause crystal defects. Hence, in the DZ-IG method, annealing of the silicon wafer is carried out so as to induce BMDs at the interior of the silicon wafer, thus forming an intrinsic gettering (IG) layer. Gettering of the impurities by the IG layer results in the formation of a denuded zone (DZ) having very few crystal defects on the surface of the silicon wafer.

The DZ layer is essential for device formation. However, when a silicon wafer on which a denuded zone (DZ) has been formed is subjected to annealing, dislocation defects (slips) occur and propagate in the DZ layer and lower the strength of the silicon wafer. In particular, if the wafer is annealed while being supported in a device such as a thermal processing boat, slip dislocations sometimes propagate from the peripheral back side portion at which the wafer is supported, If a strength of a wafer is reduced, the wafer tends to generate damage or failure in subsequent process. Hence, there has been a demand for silicon wafers having a DZ layer and excellent strength properties. As shown in Japanese Patent Application, First Publication 2002-134521, there has been known a technique for avoiding the above-described problems by removing a surface layer of a wafer. However, in such technique, increased production costs due to a larger number of operations and a higher slicing thickness can not be avoided.

Microdefects of oxide precipitate as the nuclei of oxidation-induced stacking faults (OSFs), crystal originated particles (COPs), and interstitial-type large dislocations (LDs) cause reduction in yield during the production of semiconductor devices. Therefore, it is important to produce wafers reduced in such defects. Japanese Patent Application, First Publication H11-1393 discloses a defect-free silicon wafer that has no OSFs, COPs or LDs. On the other hand, in some case, production process of semiconductor device requires silicon wafers which are not only free of OSFs, COPs or LDs, but also have a gettering ability.

DISCLOSURE OF INVENTION

Problems to be Solved by the Invention:

However, although the defect-free silicon wafers free of the above-mentioned OSFs, COPs or LDs are subjected to heat treatment during the device production process, occurrence of oxide precipitates in the wafer interior is not always ensured. Hence, during heat treatment in the DZ-IG method, it has been impossible to eliminate the possibility of propagation of slip dislocations resulting in a reduction of wafer strength.

Moreover, even in cases where the defect-free silicon wafers are not used, it is preferable to inhibit the propagation of slip dislocations during heat treatment in the DZ-IG method.

Based on the above-described consideration, the present invention provides silicon wafers in which a reduction of wafer strength has been prevented by inhibiting propagation of slips during high temperature heat treatment in the DZ-IG method at a temperature not lower than 1000°C, and also provides a method for producing such silicon wafers.

Step for Solving the Problems:

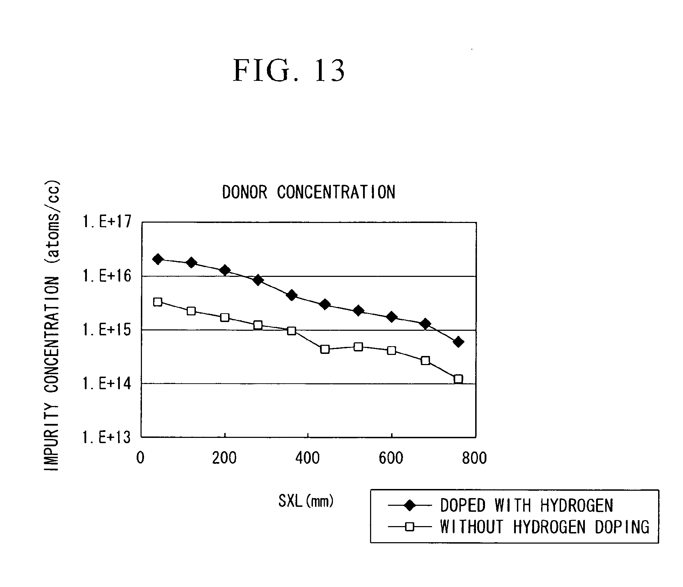

As a result of extensive investigations, inventors have found that by carrying out CZ crystal growth in an inert atmosphere including a gaseous substance containing hydrogen atoms during pulling the crystal, the bulk crystal occurs thermal donors (TD) of a high density compared with the crystal grown using conditions not doped with hydrogen (see FIG. 13).

Thermal donors are a factor for promoting the precipitation of oxides as well as a factor for fluctuating the resistivity. Therefore by performing low temperature heat treatment before the disappearance of thermal donors by high temperature annealing (Ar/H$_2$ annealing), small-size oxide precipitation nuclei can be formed in the bulk crystal to a high density. Small-size oxide precipitation nuclei have a role of inhibiting propagation of slips during high temperature thermal treatment. In a silicon wafer having a high density of precipitation nuclei, the propagation of slip dislocations is inhibited by the precipitates formed on dislocation lines in the high temperature annealing process.

Based on the above consideration, the invention provides a method for producing a silicon wafer, including:

growing a silicon single crystal by the Czochralski method in an inert atmosphere which includes a gaseous substance containing hydrogen atoms;
slicing a wafer from the silicon single crystal;
performing a high temperature heat treatment of the wafer in a non-oxidizing atmosphere at a temperature of not lower than 1000°C but not higher than 1300°C; and
prior to the high temperature heat treatment, performing a low temperature heat treatment of the wafer at a temperature lower than a temperature used in the high temperature heat treatment.

By this method, the above described problem was overcome.

The invention also provides a method for producing a silicon wafer, which includes:

growing a silicon single crystal by the Czochralski method in an inert atmosphere which includes a gaseous substance containing hydrogen atoms;
slicing a wafer from the silicon single crystal;
performing a donor killer heat treatment of the wafer to prevent fluctuation of resistivity in the wafer; and
prior to the donor killer heat treatment, performing a low temperature heat treatment of the wafer at a temperature lower than a temperature used in the donor killer heat treatment.

By this method, the above described problem was overcome.

Preferably, the temperature in the low temperature heat treatment is not lower than 400°C but not higher than 650°C, and the temperature is increased at a rate of not lower than 0.2°C/min but not higher than 2.0°C/min.

In the foregoing method for producing a silicon wafer, the low temperature heat treatment may be carried out by ramping heat treatment.

The above-described low temperature heat treatment can be used as a step for setting the difference in oxygen concentration before and after the high temperature heat treatment, based on a value measured in accordance with ASTM-F121 1979, to not less than $1.5 \times 10^{17}$ atoms/cm$^3$.

The hydrogen concentration within the inert atmosphere in the growth of the single crystal may be set in a range of not less than 0.1% by volume but not more than 20% by volume at an atmospheric pressure of 1.3 to 13.3 kPa (10 to 100 torr) within the furnace.

In the invention, it is desirable to set the oxide precipitate density after the high temperature heat treatment to not less than $1.0 \times 10^{10}$ nuclei/cm$^3$.

The silicon wafer of the invention can be produced by either of the foregoing production methods.

The method for producing a silicon wafer of the invention includes: growing a silicon single crystal by the Czochralski method in an inert atmosphere which includes a gaseous substance containing hydrogen atoms; slicing a wafer from the silicon single crystal; either performing a high temperature heat treatment of the wafer in a non-oxidizing atmosphere at a temperature of not lower than 1000°C but not higher than 1300°C or performing a donor killer heat treatment of the wafer to prevent fluctuation of resistivity in the wafer; and, prior to the high temperature heat treatment or donor killer heat treatment, performing a low temperature heat treatment of the wafer at a temperature lower than a temperature used in the high temperature heat treatment or the donor killer heat treatment. When a silicon single crystal is grown by the CZ method in an inert atmosphere including a gaseous substance containing hydrogen atoms, in the as-grown state, thermal donors (TD) occur to a high density within the bulk single crystal. When a wafer sliced from the single crystal is subjected to the above-described low temperature heat treatment, small-size oxide precipitation nuclei occur to a high density in the bulk crystal. These small-size high-density oxide precipitation nuclei can inhibit the propagation of slips that develops during high temperature heat treatment or donor killer heat treatment.

The thermal donors (TD) that have been formed to a high density in the as-grown state cause to form oxide precipitates under ramping heat treatment at a low temperature. By performing low temperature ramping heat treatment to a hydrogen-doped wafer which contains thermal donors at high concentration, small-size oxide precipitates can be formed to a high density in the bulk crystal. To inhibit propagation of slip during heat treatment, it is important to induce oxide to precipitate on the dislocation line in the direction of slip propagation at the temperature at which the dislocations start to propagate (900°C or above). By performing low temperature ramping heat treatment, it is possible to incorporate small-size precipitates within the bulk crystal to a high density and promote precipitation and inhibit propagation of slips.

Generally, silicon wafers are subjected to donor killer (DK) treatment so as to prevent fluctuation of resistivity due to thermal donors. Likewise, to minimize fluctuation of resistivity, silicon wafers subjected to hydrogen annealing or argon annealing are subjected to donor killer treatment at 600 to 700°C for about 0.5 to 2 hours prior to high temperature annealing treatment. Therefore, in the case for performing a ramping heat treatment, it is desirable to carry it out prior to the donor killer treatment (in a state where sufficient thermal donors exist).

To inhibit slip propagation in the high temperature heat treatment, small-size oxide precipitation nuclei must be formed to a high density in the bulk crystal. In the present invention, preferable oxide precipitation nuclei can be formed by setting the treatment temperature in the above-described low temperature heat treatment to not lower than 400°C but not higher than 650°C and by setting the heating rate to be not lower than 0.2°C/min but not more than 2.0°C/min, and preferably not lower than 0.3°C but not more than 1.0°C/min.

In treatment with a vertical furnace or the like, there is a strong possibility of contamination arising during heat treatment due to contaminants from the high temperature furnace wall. By using ramping heat treatment to carry out the low temperature heat treatment, the possibility of contamination can be reduced, the heating rate can be precisely controlled, and the thermal conditions can be made more rigorous. As a result, the formation state of oxide precipitation nuclei is precisely controlled, enabling wafers having the desired oxide precipitation nuclei to be obtained.

By performing the above-described low temperature heat treatment, the difference in oxygen concentration before and after the high temperature heat treatment is set to be not less than $1.5 \times 10^{17}$ atoms/cm$^3$ (ASTM-F 121 1979), enabling the oxygen concentration to be lowered. As a result, it is possible to obtain a wafer having the desired oxide precipitation nuclei by precisely controlling the formation state of oxide precipitation nuclei.

The hydrogen concentration within the inert atmosphere during the growth of a single crystal may be set in a range of not less than 0.1 % by volume but not more than 20% by volume under a atmospheric pressure of 1.3 to 13.3 kPa (10 to 100 torr) within the furnace. In a wafer sliced from a single crystal grown in this atmosphere, the desired oxide precipitation nuclei state is maintained by the above-described low temperature heat treatment, and sufficient oxide precipitation nuclei to prevent slip propagation are formed. The hydrogen concentration in the inert atmosphere may be set, under conditions of atmospheric pressure of 4.0 to 9.33 kPa (30 to 70 torr) within the furnace, to not less than 0.3% but not more than 10%.

In the present invention, by setting the oxide precipitate density to be not less than $1.0 \times 10^{10}$ nuclei/cm$^3$ after the high temperature heat treatment, slip propagation during high temperature heat treatment can be sufficiently inhibited.

The size of the above oxide precipitates is preferably about 80 to 200 nm, and more preferably about 100 nm.

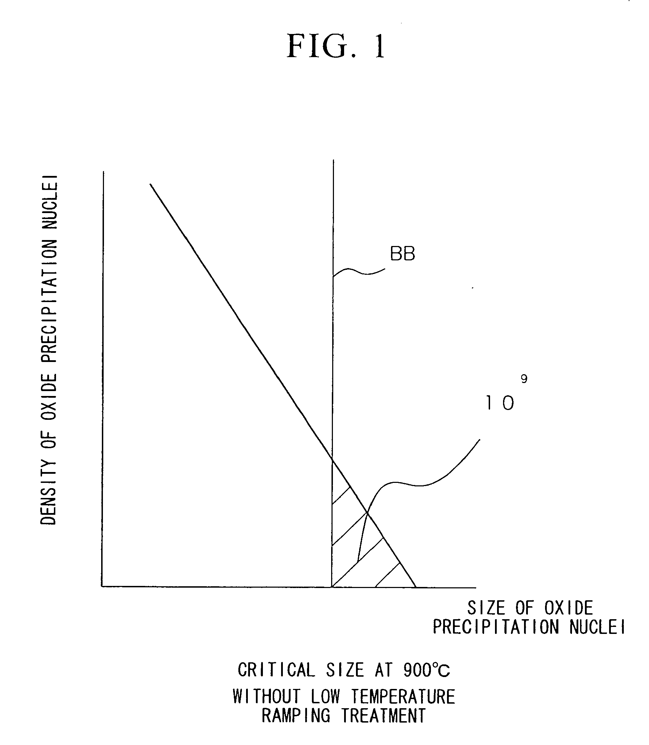

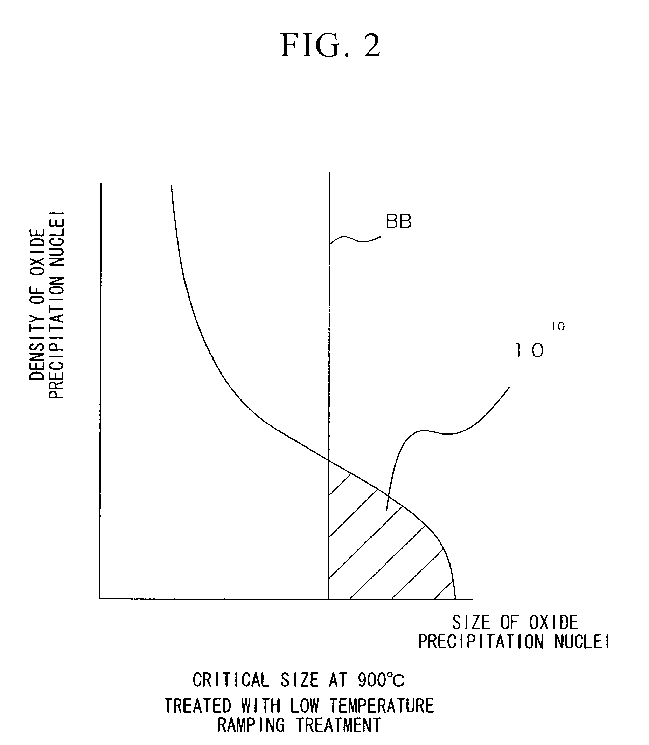

FIGS. 1 and 2 show the density of oxide precipitation nuclei on the vertical axis and the size on the horizontal axis. In the diagrams, the symbol BB represents the boundary line indicating the critical size of BMDs that remain at a temperature of not lower than 900°C.

When low temperature ramping heat treatment (low temperature heat treatment) is not performed, as shown in FIG. 1, in the bulk crystal prior to high temperature annealing (argon annealing), the density of BMDs at and above the critical BMD size at 900°C to the right of the boundary BB is on the order of $1.0 \times 10^9$ nuclei/cm$^3$. On the other hand, when low temperature ramping heat treatment is performed, because the formation of oxide precipitation nuclei is accompanied at the same time by growth of the precipitate nuclei, as shown in FIG. 2, the density of BMDs at or above the critical BMD size at 900°C to the right of the boundary BB is on the order of $1.0 \times 10^{10}$ nuclei/cm$^3$.

Hence, during high temperature annealing (argon annealing) at 1200°C or more, in a wafer that has been subjected to low temperature ramping heat treatment, a BMD density of not less than $1.0 \times 10^{10}$ nuclei/cm$^3$ is ensured and slip propagation during high temperature heat treatment is inhibited by the high density of BMDs.

Based on preliminary experiments, upon factoring in boat insertion temperature and ramping rate of the argon annealing process, the density of BMDs remaining in the wafer after high temperature annealing (argon annealing) was found to be equivalent to the density of BMDs not smaller than the critical BMD size at 900°C. Hence, the boundary was set at 900°C.

The silicon wafer of the invention can be produced by either of the methods described above.

Inventors have conducted investigations on crystal pulling technology in a hydrogen-bearing atmosphere. Based on our results, we have arrived at the following two conclusions.

First, when a single crystal is grown while gradually lowering the pulling rate using a furnace with a hot zone structure to control the thermal gradient Gc at the center of the crystal so as to be equal to or larger than the thermal gradient Ge at the periphery of the crystal, the OSF-developing region in a longisectional view of the single crystal has a downwardly convex U-like shape that is flat at the bottom. In a cross-sectional view of the crystal, at high pulling rates, the OSF-developing region exhibits a ring-like shape inside of which can be seen a COP (also called "infrared scattering defect") developing region. The ring-like OSF-developing region shrinks to the center of the crystal as the pulling rate decreases. Further reduction of the pulling rate gives rise to a dislocation cluster-developing region.

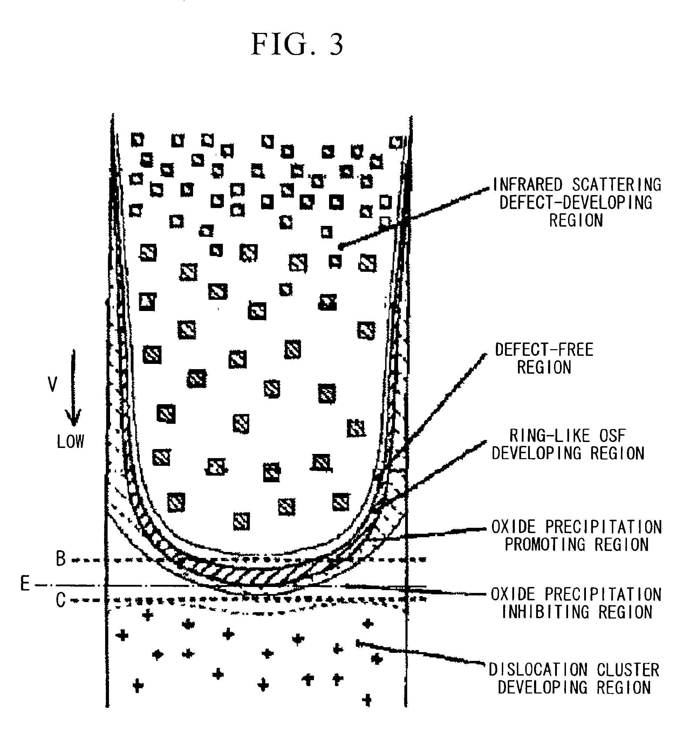

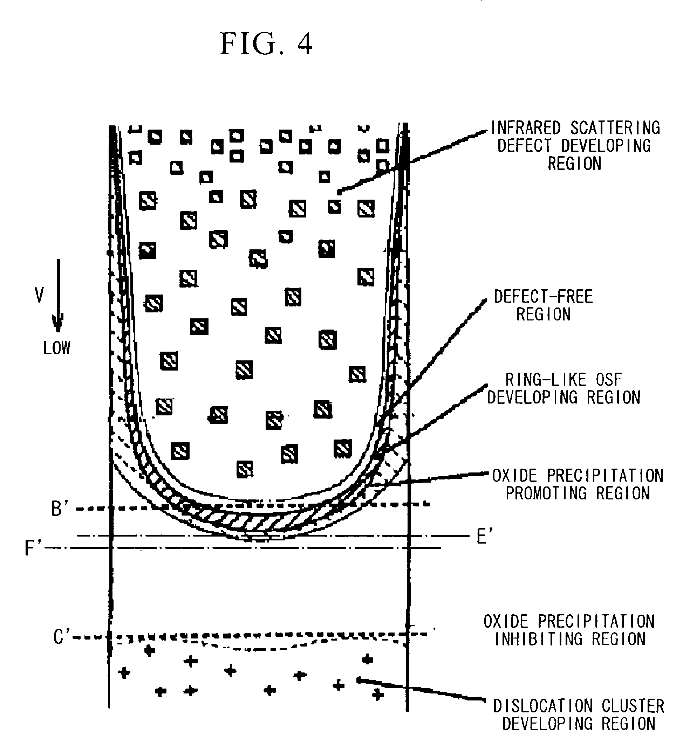

Under the above-described pulling conditions, by mixing a very small amount of hydrogen in the inert gas that is introduced to the crystal pulling furnace, the pulling rate range for achieving a defect free state is broadened; and the defect-free region expands in the axial direction of the crystal in the defect distribution within a longitudinal section of the crystal. This effect can be observed by comparing the region B-C in FIG. 3 for a crystal grown without hydrogen doping with the region B'-C' in FIG. 4 for a crystal grown with hydrogen doping.

The pulling rate conditions for the B-C region in FIG. 3 are pulling conditions near the critical rate at which the OSF-developing region vanishes at the center of the crystal. By carrying out crystal pulling under these rate conditions, the entire region in the radial direction of the crystal can be made defect-free.

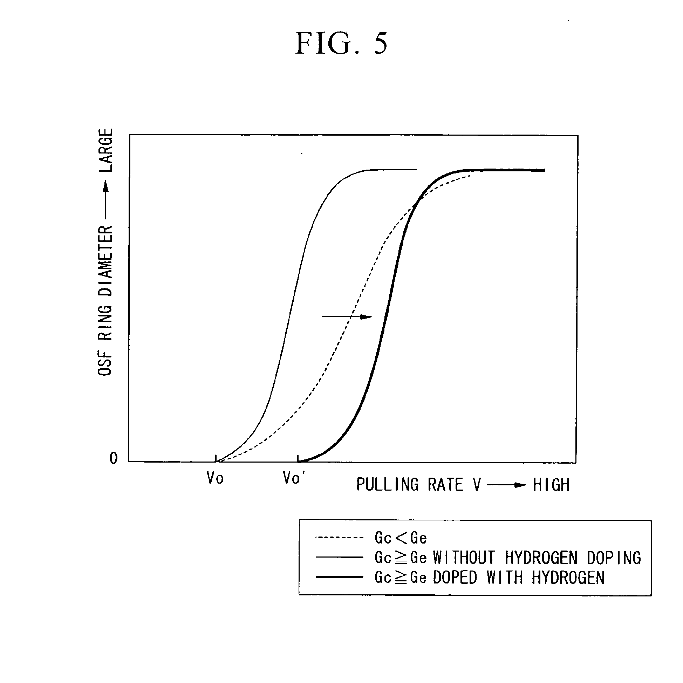

The expansion in the pulling rate range for obtaining a defect-free state due to doping of hydrogen is realized as a result of a increase in Vo and decrease in Vd, where Vo is the critical pulling rate at which the ring-like OSF-developing region vanishes at the center of the crystal, and Vd is the critical pulling rate at which dislocation clusters occur. Compared with the pulling rate range B-C in FIG. 3 for a case of not doping hydrogen, the pulling rate range B'-C' for obtaining a defect-free state shown in FIG. 4 expands toward the high-rate side (i.e., upward from B in FIG. 3) and toward the low-rate side (i.e., downward from C in FIG. 3). This effect is explained below while referring to FIG. 5.

FIG. 5 shows the degree of influence by defect distribution on the relationship between the pulling rate and the OSF ring diameter. In this graph, the dashed line represents a case in which the thermal gradient Gc at the center of the crystal is smaller than the thermal gradient Ge at the periphery of the crystal. Here, the OSF-developing region in a longisectional view of a single crystal grown while gradually lowering the pulling rate has a downwardly convex, V-like shape. In this case, as the pulling rate decreases, the OSF ring diameter gradually shrinks, converging to 0 at the critical pulling rate Vo.

The thin solid line represents a case in which hydrogen is not doped, and the thermal gradient Gc at the center of the crystal is the same as or larger than the thermal gradient Ge at the periphery of the crystal. In a longisectional view of a single crystal grown while gradually decreasing the pulling rate, the shape of OSF-developing region is changed to a U-like shape. In this case, the pulling rate at which the OSF ring diameter starts to shrink is lowered, shrinkage occurs abruptly from the starting rate, and the pulling rate converges to 0 at substantially the same critical pulling rate Vo as in the case represented by the dashed line. That is, the gradient of decrease in the ring diameter is steepened while maintaining the same critical rate Vo. As a result, near the critical rate Vo, it is possible to grow a defect-free single crystal free of dislocation clusters or COPs throughout the radial direction of the crystal. Yet the pulling rate must be kept at low rate because the critical rate Vo is not increased.

On the other hand, the thick solid line represents a case in which hydrogen is doped, and the thermal gradient Gc at the center of the crystal is the same as or larger than the thermal gradient Ge at the periphery of the crystal. In a longisectional view of a single crystal grown while gradually decreasing the pulling rate, the OSF-developing region has a U-like shape. In this case, compared with the fine solid line, the gradient of decrease in the ring diameter remains steep and the critical rate increase from Vo to Vo'. By being shifted toward the high pulling rate side, the fine solid line corresponds substantially to the thick solid line.

Hence, by combining hydrogen doping with growth conditions of a crystal free of grown-in defect, it is possible to increase the critical rate at which the ring-like OSF region vanishes at the center of the crystal. Therefore it is possible to grow, at a pulling rate higher than the conventional rate, a grown-in defect-free single crystal which, in the as-grown state, contains no dislocation clusters or COPs throughout the crystal in the radial direction thereof. Moreover, since the upper limit of pulling rate at which dislocation clusters occur is lowered from Vd to Vd' by an effect of hydrogen doping, the pulling rate range for achieving a defect-free state is broadened from B-C to B'-C'. As a result, it is possible to grow a defect-free crystal stably, and remarkably increase the production yield for crystals free of grown-in defect.

The followings are the considerations for the cause for expanding the pulling rate range for achieving a grown-in defect-free crystal by the doping of hydrogen, i.e., the cause for increasing the critical pulling rate Vo for the ring-like OSF and decreasing the critical pulling rate Vd at which dislocation clusters appear.

When a silicon wafer is heat treated in high temperature hydrogen at 1300 to 1390°C and quenched, vacancies or interstitial silicon atoms react with hydrogen to form vacancy-hydrogen or interstitial silicon-hydrogen complexes (M. Suezawa: The Division of Crystal Science and Technology, The Japan Society of Applied Physics, 110th Workshop Text (June 3, 1999), p. 11). Therefore, when a CZ crystal is grown in a hydrogen-bearing inert atmosphere, at temperatures higher than the temperatures for generating grown defects such as COPs (approx. 1100°C) and dislocation clusters (approx. 1000°C), vacancy-hydrogen complexes or interstitial silicon-hydrogen complexes are formed by reaction of hydrogen with the excess vacancies or excess interstitial silicon in the silicon crystal. Since the formation of complexes decrease the concentration of vacancy and interstitial silicon, aggregation of vacancies and interstitial silicon is inhibited. As a result, a CZ crystal is grown at a state in which COPs and dislocation clusters do not exist or have small size.

However, when a CZ crystal is grown in a hydrogen-bearing inert atmosphere and under excess vacancy conditions including sufficiently large V/G ratio, high hydrogen concentration generates macrovoids (regarded as vacancy aggregates) called "hydrogen defects" ranging from several $\mu$m to several tens of $\mu$m in sizes in the crystal (see E. lino, K. Takano, M. Kimura, H. Yamagishi: Material Science and Engineering B36 (1996), 146-149; and T.H. Wang, T.F. Ciszek, and T. Schuyler: J. Cryst. Growth 109 (1991), 155-161). It is known that interstitial silicon-type hydrogen defects (dislocation pairs thought to be aggregates of interstitial silicon) occur under excess interstitial silicon conditions at a sufficiently small V/G (Y. Sugita: Jpn. J. Appl. Phys. 4 (1965), 962).

Hence, if a crystal is pulled by the CZ method in an atmosphere that contains sufficient hydrogen, even without lowering the pulling rate below the critical rate at which the ring-like OSF region occur, it is possible to inhibit the formation of COPs. The formation of dislocation clusters is inhibited in low-speed pulling as well.

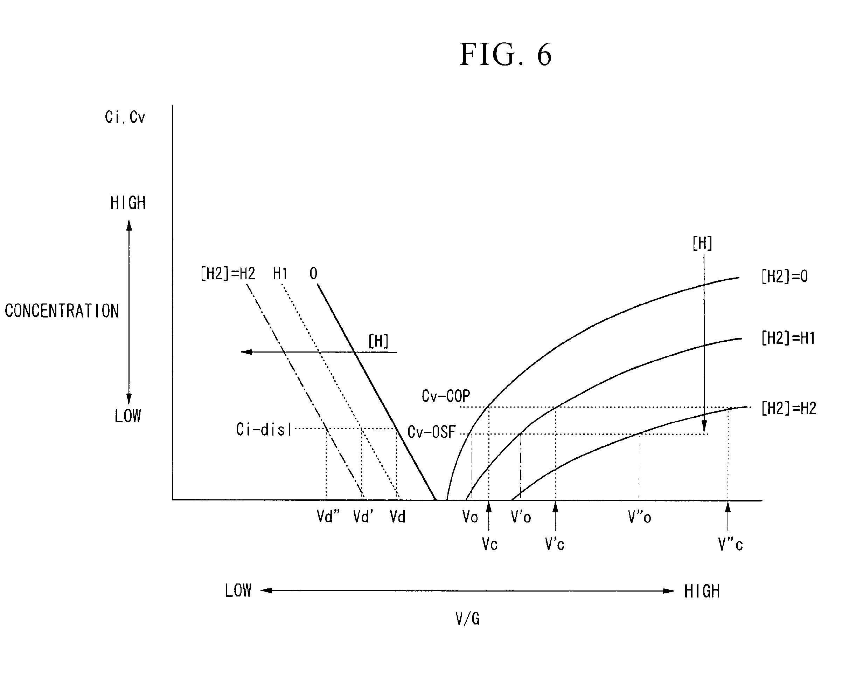

FIG. 6 shows the relationship of Ci and Cv versus V/G at temperatures not lower than 1100°C at the center of the crystal during CZ crystal growth, where Cv is a concentration of vacancies; Ci is a concentration of interstitial silicon; and V/G is a ratio of the pulling rate V to the thermal gradient G on the crystal side in the vicinity of the solid-liquid interface. The graph illustrates the effect for inhibiting the occurrence of COP and dislocation cluster in crystals containing hydrogen. In the following, the process for inhibiting formation of COPs and dislocation clusters is explained with reference to the graph. Here, Vo, Vc and Vd represent respectively the critical pulling rates at which the ring-like OSF region, COPs and dislocation clusters begin to occur at the center of the crystal or in a portion of the crystal in the radial direction thereof. Cv-OSF, Cv-COP and Ci-disl represent respectively the critical point defect concentrations at which the ring-like OSF region, COPs and dislocation clusters occur.

When a crystal is grown using a CZ furnace having a hot zone, so as to grow a grown-in defect-free crystal, designed to control the V/G ratio to satisfy Gc ≥Ge in the radial direction of the crystal, generally COPs occur in the crystal at a pulling rate higher than Vc (the case in which [H2] = 0 in FIG. 6). COPs are excess vacancy type point defects. However, when a CZ crystal is grown in an atmosphere including a gaseous substance containing hydrogen atoms (cases H1 and H2 in FIG. 6), concentration of free vacancies is decreased by the formation of complexes of vacancies and hydrogen. The decrease in the concentration of free vacancies depends on the hydrogen concentration in the crystal, and the vacancy concentration decrease with increasing hydrogen concentration in the crystal. Hence, under the presence of hydrogen, the pulling rate for OSF ring formation shifts from Vo to the high rate value, such as Vo' or Vo", and the pulling rate for COP formation also shifts from Vc to the high rate value, such as Vc' or Vc".

On the other hand, when the pulling rate is smaller than Vd (the case in which [H2] = 0 in FIG. 6), excess interstitial silicon type point defects are caused to occur, the interstitial silicon concentration satisfy Ci >Ci-disl, and dislocation clusters generally occur as secondary defects caused by the interstitial silicon. However, when the crystal is grown in an atmosphere including a gaseous substance containing hydrogen atoms ([H2] = H1 or H2 in FIG. 6), the concentration of free interstitial silicon is lowered by the formation of complexes of the interstitial silicon and the hydrogen. Therefore, the pulling rate for forming dislocation clusters shifts from Vd to the low rate value, such as to Vd' or Vd", corresponding to the critical concentration Ci-disl.

As shown in [H2] = H1 or H2 in FIG. 6, under relatively low hydrogen concentration, at a sufficiently large V/G, COP formation is not completely inhibited since the concentration of vacancy exceeds the critical concentration Cv-COP for forming COPs. However, because the vacancy concentration is lower than that of hydrogen-free condition, COPs are smaller in size.

In a crystal pulled by a rate not higher than the critical rate Vo' or Vo" for ring-like OSF formation and not lower than the critical rate Vd' or Vd" for dislocation cluster formation, the vacancy and interstitial silicon have sufficiently low concentrations so that COPs and dislocation clusters do not occur in the crystal. In addition, the crystal does neither include vacancy-type hydrogen defects called macrovoids nor interstitial silicon-type hydrogen defects as dislocation pairs. Furthermore, because the pulling rate range (margin) for a grown-in defect-free crystal is remarkably larger than the case not doped with hydrogen, it is possible to grow defect-free crystals stably at high yield.

When the V/G ratio is larger than the critical V/G condition for closing OSF ring but close to the critical condition, the ring OSF does not close at the center of the crystal and so COPs occur within the portion inside the ring. Yet, because the vacancy concentration decreases due to hydrogen doping, the COPs are of a small size. The vacancy concentration in such cases is sufficiently low that macrovoid formation does not occur.

At a pressure within the furnace of from 1.3 to 13.3 kPa (10 to 100 torr), the hydrogen concentration in the above-described inert atmosphere can be set to not less than 0.1% but not more than 20%, and preferably not less than 3% but not more than 10%. It is desirable for the atmospheric pressure within the furnace to be not less than 1.3 kPa (10 torr), preferably from 1.3 to 13.3 kPa (10 to 100 torr), and more preferably from 4.0 to 9.33 kPa (30 to 70 torr). If the partial pressure of hydrogen is low, the hydrogen concentration within the melt and the crystal will be low. The above lower limit in atmospheric pressure within the furnace has been set so as to avoid these low hydrogen concentrations. A decrease in the flow rate of argon makes it more difficult to exhaust from the furnace carbon that has degassed from the carbon heater or carbon parts and gaseous substances such as SiO that have vaporized from the melt. As a result, the carbon concentration increases and SiO agglomerates within the furnace in areas above the melt where the temperature is about 1100°C or less, generating dust which falls into the melt and causes dislocations to occur within the crystal. The above upper limit of atmospheric pressure within the furnace has been set so as to inhibit such phenomena.

The hydrogen concentration in the silicon single crystal during growth in a hydrogen-bearing inert atmosphere can be controlled through the hydrogen partial pressure within the atmosphere. Hydrogen within the atmosphere dissolves in the silicon melt and reaches a steady (equilibrium) state, and the hydrogen concentrations within the liquid and solid phases are distributed by segregation of concentration at the time of solidification of a crystal. As a result, hydrogen is introduced into the crystal.

According to Henry's law, the hydrogen concentration within the melt is dependent on the hydrogen partial pressure within the gas phase and is expressed as

$$P_{H2} = kC_{LH2},$$

where $P_{H2}$ is the hydrogen partial pressure in the atmosphere, $C_{LH2}$ is the hydrogen concentration in the silicon melt, and k is a coefficient between the $P_{H2}$ and $C_{LH2}$.

The hydrogen concentration in the silicon single crystal is determined by the relationship between the hydrogen concentration in the melt and segregation, and is expressed as:

$$C_{SH2} = k'C_{LH2} = (k'/k)P_{H2},$$

where $C_{SH2}$ is the hydrogen concentration in the crystal, and k' is the segregation coefficient for hydrogen between the silicon melt and the silicon crystal.

As shown by the above formulas, the hydrogen concentration in the crystal just after solidification can be controlled to a desired constant concentration in the axial direction of the crystal by controlling the hydrogen partial pressure within the atmosphere.

In the silicon wafer of the invention, by growing the crystal in an inert atmosphere which includes a gaseous substance containing hydrogen atoms, it is possible to have the entire wafer consist solely of an interstitial silicon-rich region (PI region). Because the wafer in this case does not contain a PV region, homogeneity can be maintained throughout the wafer.

Here, "homogeneity in wafer" refers to, for example, homogeneity in the density and size of oxide precipitates and homogeneity of the DZ width. Letting the parameters at this time include the oxygen concentration and the heat treatment temperature and time, the oxygen concentration, base on a value measured in accordance with ASTM-F121 1979, may be set to from $10 \times 10^{17}$ to $20 \times 10^{17}$ atoms/cm$^3$, and preferably from $12 \times 10^{17}$ to $18 \times 10^{17}$ atoms/cm$^3$; the heat treatment temperature may be set at from 450 to 1400°C, and preferably from 1100 to 1250°C; and the heat treatment time may be set within a time range more than 0 second. In this way, it is possible to obtain excellent wafers in which the oxide precipitate density and size and the DZ width are all highly uniform within the plane of the wafer.

At this time, rapid thermal annealing (RTA) treatment may be carried out while setting the oxygen concentration (Oi) in the single crystal within a high value range of $10 \times 10^{17}$ to $20 \times 10^{17}$ atoms/cm$^3$ (ASTM-F121 1979). In this way, without carrying out lengthy, high temperature heat treatment to effect the outward diffusion of oxygen in DZ layer formation, it is possible to obtain excellent wafers which have homogenous distribution of oxide precipitate density and size ensuring a sufficient gettering ability, and homogeneous DZ width sufficient to make the device active region completely defect free. Moreover, the oxygen concentration (Oi) in the single crystal may be set within a low value range of $10 \times 10^{17}$ atoms/cm$^3$ or less (ASTM-F121 1979). In this way, even when heat treatment of the device is carried out, the formation of oxide precipitates in the device active region is suppressed, making it possible to reduce or eliminate oxide precipitates. As a result, it is possible to obtain excellent wafers capable of maintaining device characteristics without deterioration.

In a method for growing a silicon single crystal of the invention, the silicon single crystal is pulled in an inert atmosphere including a gaseous substance containing hydrogen atoms. Using such a method, it is possible to expand the PI region pulling rate range for pulling a single crystal which is free of COPs or dislocation clusters throughout the radial direction and which is composed entirely of an interstitial silicon-rich region (PI region). As a result, the straight body portion of the single crystal can be made an interstitial silicon-rich region (PI region) which contains no dislocation clusters. Conventionally, the P1 region pulling rate has had to be set within a very narrow range for pulling a single crystal free of grown-in defect. In the invention, by broadening the range of the PI region pulling rate, it is possible to grow a single crystal free of grown-in defect easily at a pulling rate faster than the conventional rate.

Here, comparison of the PI region pulling rate range in a hydrogen-bearing atmosphere with the PI region pulling rate range in an hydrogen-free inert atmosphere is made under conditions in which axial thermal gradient G within the crystal immediately after solidification is in a constant and unchanging state.

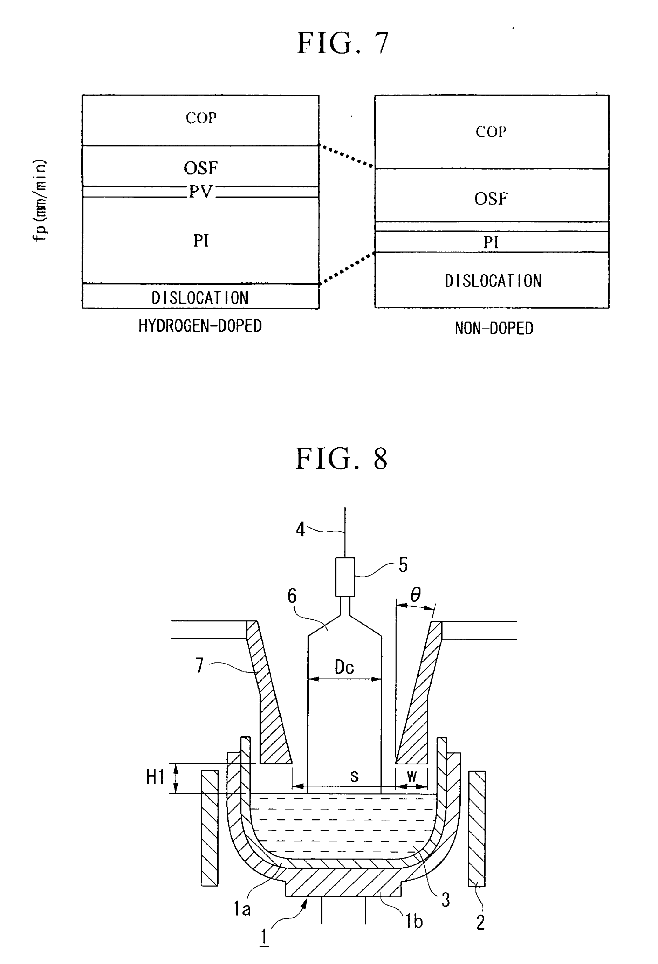

Specifically, by pulling the silicon single crystal in a hydrogen-bearing atmosphere, the PI region pulling rate range (margin) for pulling a grown-in defect-free single crystal composed of a region (PI region) free of interstitial silicon-type grown-in defect can be expanded to at least 4 times, and as shown in FIG. 7, even 4.5 times as large, as the margin for pulling a single crystal in an atmosphere containing no hydrogen.

In this case, it is also possible to shrink the ring-like OSF-developing region. The size of the PV region (vacancy-type region free of grown-in defect) does not change by the doping of hydrogen.

In the present invention, as it is exemplified by the above-described PI region pulling rate range, it is possible to enlarge the pulling rate range required to pull a silicon single crystal free of grown-in defect. As a result, a plurality of single crystals can be pulled under identical conditions and pulling rate selection can be carried out more easily, enabling grown-in defect-free single crystals to be pulled. That is, in cases for pulling a plurality of single crystals free of grown-in defect by pulling the crystals a plurality of times with the same apparatus or at the same time with a plurality of apparatus, even though selecting the pulling rate conditions much simpler than that used in the prior art, it is possible to set the pulling rate within the range for pulling single crystals free of grown-in defect. Thus it is possible to pull a single crystal of desired quality. Such simplification enhances the efficiency of the operation and substantially reduces production costs of silicon single crystals and of silicon wafers produced from these silicon single crystals.

The substance containing hydrogen atoms used in the invention is a substance which, when dissolved in a silicon melt, thermally decomposes and can supply hydrogen atoms to the silicon melt. By introducing the substance containing hydrogen atoms into an inert gas atmosphere, the hydrogen concentration within the silicon melt can be increased. Specific examples of the substance containing hydrogen atoms include inorganic compounds containing hydrogen atoms such as hydrogen gas, $H_2O$ and HCl, and various other types of substance containing hydrogen atoms such as silane gas, hydrocarbons such as $CH_4$ and $C_2H_2$, alcohols and carboxylic acids. The use of hydrogen gas as the substance containing hydrogen atoms is especially preferred. The inert gas is preferably inexpensive argon gas, although various other rare gases such as helium, neon, krypton and xenon may be used singly or in admixture.

In the invention, the concentration of the substance containing hydrogen atoms in the hydrogen-bearing atmosphere is expressed by equivalent concentration of hydrogen gas. The equivalent concentration of hydrogen gas is used because of the following reason. Thermal decomposition of the substance containing hydrogen atoms provides a certain amount of hydrogen atoms. That amount is dependent on the numbers of hydrogen atoms originally composed in the substance containing hydrogen atoms. For example, 1 mole of $H_2O$ compose 1 mole of $H_2$, whereas 1 mole of HCl compose only 0.5 mole of $H_2$. Therefore, in the present invention, hydrogen-bearing atmosphere obtained by introducing a predetermined concentration of hydrogen gas into an inert gas is used as a standard. It is preferable to control the concentration of the substance containing hydrogen atoms so as to obtain an atmosphere equivalent to the standard atmosphere. At that time the preferable concentration of substance containing hydrogen atoms is expressed by the equivalent concentration of hydrogen gas.

That is, assuming that the substance containing hydrogen atoms dissolves in the silicon melt, thermally decomposes in the high temperature silicon melt and is converted to hydrogen atoms, the addition of substance containing hydrogen atoms is controlled so that the equivalent concentration of hydrogen gas in the atmosphere following conversion falls within the predetermined range of concentration.

In the method for producing a silicon wafer of the invention, a silicon single crystal is formed in a hydrogen-bearing atmosphere composed of an inert gas that includes a substance containing hydrogen atoms. The hydrogen atoms from the substance containing hydrogen atoms dissolve in the silicon melt and are taken up within the silicon lattice during solidification of the silicon.

The critical pulling rate cannot be increased effectively by the insufficient doping of hydrogen. On the other hand, too much doping of hydrogen generates a risk of combustion or detonation in the case of occurring leakage of air into the furnace. Hence, the lower limit in the amount of hydrogen gas addition is preferably not less than 0.1 vol%, and more preferably not less than 3 vol%. Substantially no effect can be observed by the doping of hydrogen at less than 0.1%. An equivalent concentration of hydrogen gas in excess of 50% (that is, a hydrogen partial pressure of 6.75 kPa) is undesirable for safety reasons. In such a concentration, there is high risk of detonation by an oxygen leakage into the CZ furnace. An equivalent concentration of hydrogen gas greater than 20% (hydrogen partial pressure = 2.7 kPa) is not preferable. In such a concentrations, even though detonation do not occur, still there is an high risk of combustion. The safety hazard can be avoided at a hydrogen concentration of 20% or less. In such a hydrogen concentration, even should combustion occur within the furnace due to an oxygen leak or the like, fluctuation of pressure at the time of combustion does not exceed atmosphere. Thus, the upper limit for hydrogen gas addition is determined. The concentration of the hydrogen-containing substance (hydrogen gas) is preferably not less than 0.1% but not more than 20%, and more preferably in a range of 3 to 10%.

When oxygen gas ($O_2$) is contained in the inert atmosphere, the difference between the twice the oxygen gas concentration and equivalent concentration of hydrogen molecule of the gaseous substance containing hydrogen atoms is set to be not less than 3 vol%. If the difference between the twice the oxygen gas concentration and equivalent concentration of hydrogen molecule of the gaseous substance containing hydrogen atoms is less than 3 vol%, the hydrogen atoms incorporated into the silicon crystal will not provide an effect for inhibiting generation of grown-in defect such as COPs and dislocation clusters.

If nitrogen is present as an impurity in the inert gas at a high concentration, dislocations may form in the silicon crystal. In an usual conditions of atmospheric pressure of 1.3 to 13.3 kPa (10 to 100 torr) within the furnace, it is preferable to set the nitrogen concentration to be 20% or less.

Hydrogen gas can be supplied to the CZ furnace as the substance containing hydrogen atoms by being fed into the crystal pulling furnace through a specialized line from a commercial hydrogen gas cylinder, a hydrogen gas storage tank, or a hydrogen tank that stores hydrogen in a hydrogen occlusion alloy.

When a single crystal is grown while gradually lowering the pulling rate using a conventional hot-zone structure in which the thermal gradient Gc at the center of the crystal is smaller than the thermal gradient Ge at the periphery of the crystal, that is Ge > Gc, the ring-like OSF-developing region in a longisectional view of the crystal has a downwardly pointed V-like shape. When hydrogen doping is combined with such pulling conditions, the hydrogen doping causes effects for increasing Vo and Vc and decreasing Vd, where Vo and Vc are the critical pulling rate at which the ring-like OSF-developing region and COPs begin to occur in central portion of the crystal; and Vd is the critical pulling rate at which which dislocation clusters begin to occur in a portion of the crystal. Therefore, even though Ge > Gc, there will be a possibility for providing a completely grown-in defect-free crystal without COPs or dislocation clusters provided that Ge and Gc have relatively close values. Yet, compared to the case where Ge ≤ Gc, the pulling rate margin in this case is insufficient for stable production of crystals free of grown-in defect. Moreover, in the case having largely different values for Ge and Gc satisfying Ge > Gc, a pulling rate margin for providing a grown-in defect-free state cannot be obtained even with the doping of hydrogen.

The invention was completed based on the above-described findings. The silicon wafer of the invention is obtained by performing heat treatment in a low temperature heat treatment and a high temperature heat treatment as described above to a wafer sliced from a silicon single crystal grown by the CZ method in an inert atmosphere that includes a gaseous substance containing hydrogen atoms.

The high temperature treatment step may be, for example, rapid thermal annealing (RTA). RTA can be carried out under conditions such as the following: 1100 to 1350°C; more than 0 second; in an atmosphere of argon, helium, or $NH_3$-containing argon or helium. In this way, without carrying out high temperature heat treatment for a long period of time to effect the outward diffusion of oxygen in DZ layer formation process, it is possible to obtain wafers having oxide precipitates of a density and size that ensure a sufficient gettering ability and a DZ width sufficient for making the device active region completely free of defect.

In the prior art, wafers free of grown-in defect could not avoid mixed occurrence of PV region and PI region or the ring-like OSF-developing region. Even after RTA treatment like that described above, such conventional grown-in defect-free wafers have problems of heterogeneous occurrence of defect distribution. For example, the PV region and ring-like OSF region which have been given excess vacancies during crystal growth have oxide precipitates of larger densities and sizes than those of PI region. In addition, by an oxidation treatment during the device formation process, the ring-like OSF region occurs OSFs. Such problems are overcome in the present invention which can provide grown-in defect-free wafers composed entirely of a PI region and have homogeneous status throughout the wafer plane.

Advantageous Effects of the Invention

According to the present invention, a silicon single-crystal ingot containing thermal donors in a high density can be obtained by growing a silicon single-crystal ingot in an inert gas atmosphere which includes a gaseous substance containing hydrogen atoms. By performing low temperature ramping heat treatment to a silicon wafer obtained from this silicon single-crystal ingot, small-size oxide precipitates can be formed to a high density in the bulk crystal. Introducing small-size precipitates to a high density in the bulk crystal in this way accelerates precipitation in high temperature heat treatment so that sufficient oxide precipitates are made to precipitate onto the dislocation line in the direction of slip propagation at the temperature (900°C) at which slip dislocations begin to propagate during heat treatment, thus enabling slip propagation to be inhibited.

BRIEF DESCRIPTION OF THE DRAWINGS

FIG. 1 is a graph showing the density and size distribution of oxide precipitation nuclei in a bulk crystal before high temperature annealing.
FIG. 2 is a graph showing the density and size distribution of oxide precipitation nuclei in a bulk crystal after performing low temperature ramping heat treatment, but before high temperature annealing.
FIG. 3 is a defect distribution diagram in a longitudinal section of a single crystal grown while gradually lowering the pulling rate. The diagram shows a case in which the thermal gradient Gc at the center of the crystal is the same as or larger than the thermal gradient Ge at the periphery of the crystal.
FIG. 4 is a defect distribution diagram in a longitudinal section of a single crystal grown while gradually lowering the pulling rate. The diagram shows a case in which the thermal gradient Gc at the center of the crystal is the same as or larger than the thermal gradient Ge at the periphery of the crystal, and in which hydrogen has been doped.
FIG. 5 is a graph showing the degree of influence by defect distribution on the relationship between the pulling rate and the OSF ring diameter.
FIG. 6 shows the relationship of the vacancy concentration Cv and interstitial silicon concentrations Ci versus the ratio V/G of the pulling rate V to the thermal gradient G on the crystal side in the vicinity of the solid-liquid interface, at a temperature at the center of the crystal during CZ crystal growth of 1100°C or more.
FIG. 7 is a schematic diagram showing the changes in the pulling rate region due to hydrogen doping.
FIG. 8 is a vertical sectional view of a CZ furnace suitable for producing silicon single crystals according to the method for producing a single crystal in the present embodiment.
FIG. 9 is a graph illustrating the various defect developing regions in terms of the relationship between V/G and hydrogen concentration. It can be observed an expansion of the V/G region for defect formation due to hydrogen doping.
FIG. 10 is a graph showing the relationship between a position in a crystal and the pulling rate range (margin) at which a grown-in defect-free region can be obtained.
FIG. 11 is a schematic diagram showing a single-wafer type apparatus for ramping heat treatment, which can be used for carrying out the low temperature heat treatment.
FIGS. 12A, B and C show sectional photographs of single crystals in a V-type pull test to verify changes in each crystal region due to hydrogen doping.
FIG. 13 is a graph showing the thermal donor densities (impurity concentrations) at various places in a crystal pulled with hydrogen doping and a crystal pulled without hydrogen doping.

Explanation of Reference Symbols

1: Crucible
1a: Quartz crucible
1b: Graphite crucible
2: Heater
3: Raw material melt
4: Pull shaft
5: Seed chuck
6: Single crystal
7: Heat shield

BEST MODE FOR CARRYING OUT THE INVENTION

Embodiments of the invention are described below with reference to the drawings.
FIG. 8 is a vertical sectional view of a CZ furnace suitable for working the silicon single crystal growing process in the present embodiment.

First, the construction of the CZ furnace is described.

As shown in FIG. 8, the CZ furnace has a crucible 1 that is centrally located within a furnace chamber, and a heater 2 disposed outside of the crucible 1. The crucible 1 has a double construction composed of an inner quartz crucible I a which holds therein a raw material melt 3, and an outer graphite crucible 1b which holds the inner quartz crucible 1a. The crucible is rotated and vertically driven by a supporting shaft commonly referred to as a pedestal. A cylindrical heat shield 7 is provided above the crucible 1. The heat shield 7 is composed of an outer graphite shell packed on the inside with a graphite felt. The heat shield 7 has an inner face which is tapered so that the inside radius gradually decreases from the top periphery to the bottom periphery. At the top of the heat shield 7, the outer face is a tapered surface which matches the inner face, whereas the outer face at the bottom portion is a substantially straight surface. Hence, the thickness of the heat shield 7 gradually increases in the downward direction.

This CZ furnace is capable of growing a 200 mm single crystal having a target diameter of, for example, 210 mm, and a body length of, for example, 1200 mm. The heat shield 7 provides a hot zone structure in which the thermal gradient Gc at the center of the crystal is the same as or larger than the thermal gradient Ge at the periphery of the crystal.

Specific example for the heat shield 7 may consist of an outside diameter for the portion entering the crucible of 470 mm, a minimum inside diameter S at the lowermost end of 270 mm, a width W in the radial direction of 100 mm, and an angle by the inside face shaped as an inverted truncated cone to the vertical direction of 21°. In addition, the crucible 1 may have an inside diameter of, for example 550 mm, and the bottom end of the heat shield 7 may have a height H from the melt surface of, for example 60 mm.

When pulling is carried out using a single crystal growing apparatus of the above cross-sectional construction, the axial thermal gradient from the melting point to 1370°C is from 3.0 to 3.2°C/mm at the center (Gc) of the single crystal and from 2.3 to 2.5°C/mm at the outside periphery (Ge), giving a ratio Gc/Ge of about 1.3. This state remains substantially unchanged even when the pulling rate is varied.

Next, the procedure for setting the operating conditions for growing a silicon single crystal is explained.

First, in order to determine the allowable ranges in the hydrogen concentration and the pulling rate at which a defect-free crystal can be obtained, the hydrogen concentration is set to mixing ratios of 0, 0. 1, 3, 5, 8 and 10 vol%, and a single crystal of the target diameter (e.g., 210 mm) is grown under each of these conditions.

That is, the crucible is loaded with, for example, 130 kg of high-purity polycrystalline silicon, and p-type (e.g., boron, aluminum, germanium) or n-type (phosphorus, arsenic, antimony) dopant is doped in order to set the electrical resistivity of the single crystal to the desired value, such as 10 Ω·cm. The interior of the apparatus is controlled at argon atmosphere of reduced pressure of 1.33 to 13.3 kPa (10 to 100 torr), and hydrogen is introduced into the furnace at the specific mixing ratios mentioned above of 10 vol% or less with respect to argon.

The silicon is heated with the heater 2, turning it into a melt 3, a seed crystal mounted on a seed chuck 5 is immersed in the melt 3, and crystal pulling is carried out while rotating the crucible I and the pull shaft 4. The crystal orientation may be set to {100}, {111} or {110}. After necking down the seed to make the crystal dislocation free, a shoulder is formed and the crystal is grown to have the target body diameter.

When the crystal body has reached a length of 300 mm, for example, the pulling rate is adjusted to a rate, such as 1.0 mm/min, that is sufficiently higher than the critical rate. Next, the pulling rate is lowered in a substantially linear manner in accordance with the pull length so that the pulling rate falls below the critical rate, to 0.3 mm/min for example, once the body has reached a length of, say, 600 mm. The body is then grown to a length of perhaps 1200 mm at this pulling rate and tailing is carried out under normal conditions, after which crystal growth is brought to an end.

Single crystals that have been grown under different hydrogen concentrations are vertically sectioned along the pull axis so as to fabricate plate-like test pieces containing a portion near the pulling axis. Copper decoration is then carried out in order to examine the distribution of grown-in defects. First, each test piece is immersed in an aqueous copper sulfate solution, then air dried and subsequently heat treated in a nitrogen atmosphere at 900°C for about 20 minutes. Next, to remove the copper silicide layer at the surface of the test piece, the test piece is immersed in a $HF/HNO_3$ mixed solution and several tens of microns of material at the surface layer is etched away. The position of the OSF ring on the test piece and the distribution of the various defect regions are then examined by x-ray topography. Also, the COP density in this slice may be examined by a suitable technique such as the OPP method, and the dislocation cluster density may be examined by Secco etching.

When an apparatus for pulling single crystal satisfy the relationship Gc/Ge ≥ 1, a crystal pulled by such an apparatus shows a defect distribution occurring the ring-like OSF region of U-shape in the longitudinal section as shown in FIG. 3. As the hydrogen concentration increases, the defect-free region expands in the manner of B'-C' in FIG. 4, enlarging the pulling rate range (margin) for obtaining a defect-free crystal.

The grown-in defect free region for a single crystal composed of an oxide precipitation accelerating region (PV region) which is a vacancy type region free of grown-in defect and a interstitial silicon type region (PI region) free of grown-in defect is represented by E'-C' in FIG. 4. As represented by F'-C' in FIG. 4 ,the present embodiment expands the pulling rate range for the interstitial silicon-rich region, which is a pulling rate range for pulling grown-in defect-free single crystals composed entirely of a PI region. Specifically, as shown in FIG. 7, the PI region margin in this case is at least 4 times larger than the PI region margin for the case in which atmospheric condition for crystal pulling contains no hydrogen.

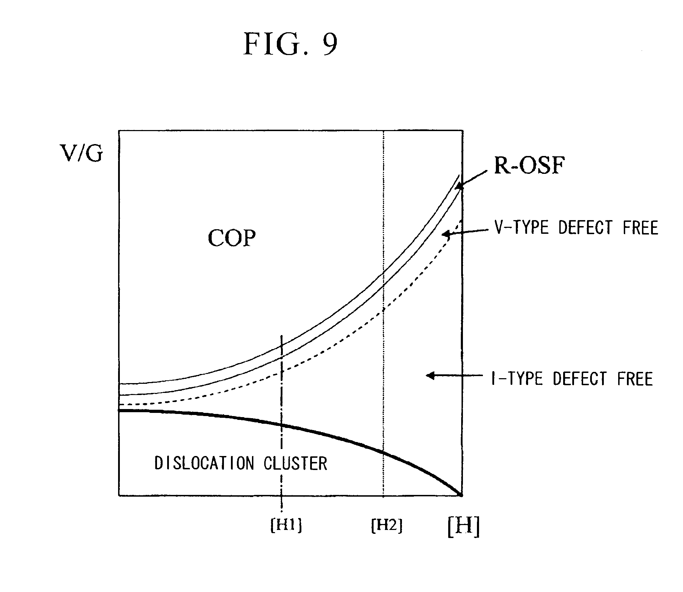

By carrying out the above-described pulling experiments, it is possible to determine the relationship (FIG. 9) between the V/G ratio and the hydrogen concentration for various defect regions such as COP region, OSF ring region, V-type grown-in defect-free region (PV region), 1-type grown-in defect-free region (PI region), and dislocation cluster region respectively.

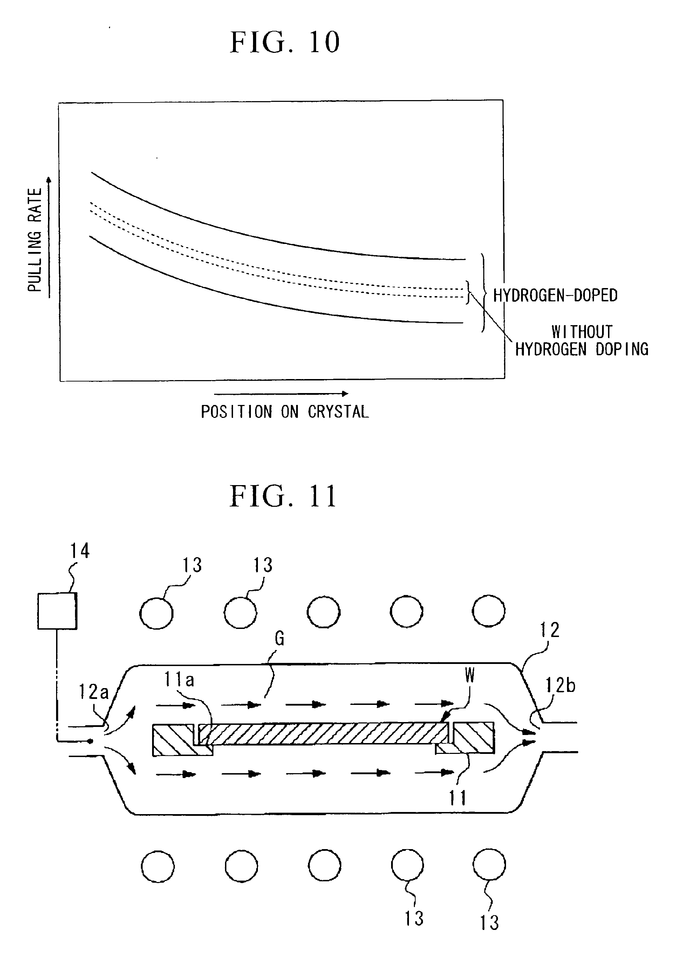

Moreover, in carrying out such experiments, pulling rates are changed for several deferent portions such as from 300 mm to 600 mm, from 500 mm to 800 mm, and from 700 mm to 1000 mm. As a result, the relationship between the pulling rate range (margin) for obtaining a grown-in defect-free crystal and the axial position on the crystal (FIG. 10) can be determined. The operating conditions for obtaining a grown-in defect-free single crystal can be selected from FIG. 10.

In the present embodiment, when a silicon single crystal is grown by the Czochralski method in an inert atmosphere including a gaseous substance containing hydrogen atoms, it is not indispensable that a magnetic field is applied to the melt. While, it is possible to use a magnetic field applied MCZ method.

Thus, by pulling a silicon single crystal in an inert atmosphere including a gaseous substance containing hydrogen atoms, the crystal can be pulled while enlarging at least four-fold the PI region pulling rate range for pulling a single crystal composed of an interstitial silicon-rich region (PI region) that contains no COPs or dislocation clusters throughout the radial direction of the crystal. Hence, all of the straight body portion of the single crystal can be made an interstitial silicon-rich region (PI region). Conventionally, it has been necessary to set the PI region pulling rate within a very narrow range for pulling a single crystal free of grown-in defect. By expanding the PI region pulling rate range, it is possible to grow single crystals free of grown-in defect extremely easily at a higher pulling rate than the conventional rate.

Next, various wafer production methods are described.

By setting the pulling rate within the pulling rate range indicated by the solid lines in FIG. 10 at the corresponding crystal positions, a crystal can be grown which is completely free of grown-in defects throughout the whole portion from top to bottom.

Moreover, by hydrogen doping, pulling rate range (margin) for a grown-in defect-free crystal can be remarkably enlarged, and the production yield of grown-in defect-free crystals is greatly improved. This effect can be observed in FIG. 10, where dashed line indicates the pulling rate range in the prior art not adding hydrogen, and the solid line indicates the range of the present invention.

If the pulling rate is set to a rate that is higher than the upper limit value represented by the solid lines in FIG. 10 but not more than 1.7 times the upper limit value, even though the crystal is not completely free of grown-in defects, a crystal can be grown to have the COP sizes of not larger than 0.1 $\mu$m. If such a crystal is annealed in an atmosphere of hydrogen or argon, for example, the near-surface region to a depth of not less than 1 $\mu$m can be rendered free of grown-in defects. In addition, since defect sizes in the crystal are not larger than 0. 1 $\mu$m, the COPs can be made to disappear completely in the region from the surface layer to a depth of about 1 $\mu$m by annealing, for example, at 1110°C for about 2 hours.

After a silicon single crystal ingot containing the desired concentrations of hydrogen and oxygen has thus been obtained by the CZ method, the ingot undergoes conventional processing. The crystal is sliced into wafers with a cutter such as an internal diameter (ID) saw or a wire saw. The sliced wafers then pass through such operations as periphery grinding, lapping, etching and polishing, and are thereby rendered into finished silicon single-crystal wafers. In addition to these operations, various other operations such as cleaning may also be carried out. Suitable changes in these processing operations may be made depending on the intended purpose, such as changes in the order of the operations or the omission of particular operations.

The method for producing a silicon wafer according to the present embodiment includes, as heat treatment of the thermal donors, a high temperature heat treatment step such as hydrogen annealing or argon annealing at a temperature of not lower than 1000°C but not higher than 1300°C in a non-oxidizing atmosphere, and a low temperature heat treatment step which is carried out under the presence of sufficient thermal donors prior to donor killer treatment. The donor killer treatment is carried out prior to the high temperature heat treatment, for example, at 650°C for about I hr in order to suppress the fluctuation of resistivity.

This low temperature heat treatment step is carried out at a temperature of not lower than 400°C but not more than 650°C, at a temperature increase rate of not lower than 0.2°C/min but not more than 2.0°C/min, and by ramping heat treatment. In the low temperature heat treatment step, it is more preferable to set the temperature range to not lower than 500°C but not more than 600°C and/or to set the rate of temperature increase to not lower than 0.3°C/min but not more than 1.0°C/min. This low temperature heat treatment step is carried out in such a way that the difference in oxygen concentration before and after the high temperature heat treatment step is not less than $1.5 \times 10^{17}$ atoms/cm$^3$ (ASTM-F121 1979), and the oxide precipitate density after high temperature heat treatment is not less than $1.0 \times 10^{10}$ nuclei/cm$^3$.

FIG. 11 shows a single-wafer type ramping thermal processor for carrying out the low temperature heat treatment step.

As shown in the diagram, this thermal processor has an annular susceptor 11 on which a silicon wafer W can be placed, and a reaction chamber 12 which houses therein the susceptor 11. Halogen lamps 13 for heating the silicon wafer W are disposed outside of the reaction chamber 12.

The susceptor 11, which is made of a material such as silicon carbide, has a step 11a on the inner peripheral side. The outer periphery of the silicon wafer W is placed on top of the step 11a. The reaction chamber 12 has a feed inlet 12 through which an ambient gas G is supplied to the surface of the silicon wafer W and a discharge outlet 12b through which the ambient gas G that has been supplied is discharged. The feed inlet 12a is connected to a feed source 14 of the ambient gas G.

High temperature heat treatment in this thermal processor is performed on the silicon wafer W as follows. The silicon wafer W is placed in the susceptor 11. Next, while the ambient gas G is supplied from the feed inlet 12a to the surface of the silicon wafer W, the lamp 13 is lighted and heat treatment is carried out under temperature conditions and a rate of temperature increase within the above-indicated ranges. This low temperature heat treatment generates oxide precipitation nuclei within the silicon wafer W.

By growing a silicon single crystal using the CZ method in an inert atmosphere which includes a gaseous substance containing hydrogen atoms, thermal donors (TDs) in the as-grown state are formed to a high density within the bulk crystal of this single crystal. By performing the above-described low temperature heat treatment step to a wafer sliced from this single crystal, small-size oxide precipitation nuclei are generated to a high density in the bulk crystal. These small-size high-density oxide precipitation nuclei inhibit the slip propagation that arises in high temperature heat treatment.

In the above low temperature heat treatment step, by performing low temperature ramping heat treatment on the hydrogen-doped wafer containing a high density of

thermal donors, it is possible to form the small-size oxide precipitation nuclei to a high density in the bulk crystal. The small-size oxide precipitation nuclei are necessary for suppressing slip propagation in the high temperature heat treatment step.

To inhibit slip propagation during the high temperature heat treatment step, it is important to have the oxide to precipitate on the dislocation line in the direction of slip propagation at the temperature at which dislocations begin to propagate (900°C or above). Therefore, in the low temperature heat treatment step, setting of the temperature range higher than the above-indicated temperature range is undesirable because of the possibility that slips will propagate in the high temperature heat treatment step. Setting of the temperature range lower than the above-indicated temperature range is undesirable because of the possibility that formation of the necessary oxide precipitation nuclei is not promoted.

Examples of high temperature heat treatment include hydrogen annealing and argon annealing by the DZ-IZ method, and SIMOX annealing performed at elevated temperatures of 1300°C or above.

It is also possible to apply rapid thermal annealing (RTA) treatment which is capable of rapidly raising and lowering the temperature in milliseconds or thermal processing with laser irradiation.

In the present embodiment, by pulling a silicon single crystal in an inert atmosphere which includes a gaseous substance containing hydrogen atoms, a silicon wafer having sufficient thermal donors can be obtained. By performing the above-described low temperature ramping heat treatment on such a silicon wafer, it is possible to form $SiO_4$ which remains in the wafer after the argon annealing and is capable of stopping slip propagation.

Such wafers can be used in this state as conventional PWs (polished wafers, mirror wafers) for device fabrication, and can also be used as substrates for silicon-on-insulator (SOI).

Results of V type test pulling using an apparatus for pulling a silicon single crystal are explained in the following.

The pulling rate was varied, in terms of the ratio to the maximum pulling rate, from 0.7 to 0.35 to 0.7. The hydrogen concentrations and pressures within the furnace during pulling were set respectively to (a) 0% and 30 torr, (b) 6% and 30 torr, and (c) 6% and 70 torr. In each case, the crystal was pulled and a surface in the axial direction of the crystal was examined.

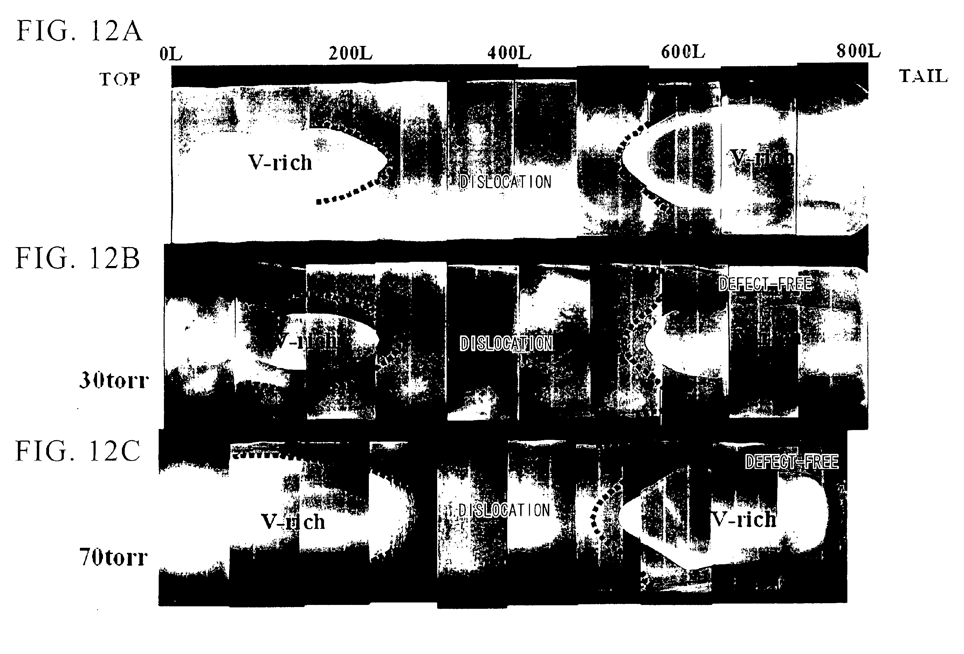

The cut surfaces of the above crystals were examined after the below-described treatment. FIGS. 12A, B and C show the results of the examination.

The single crystals that had been grown in this way under different hydrogen concentrations were vertically sectioned along the pull axis so as to fabricate plate-like test pieces containing a portion near the pull axis. Copper decoration was then carried out in order to examine the distribution of grown-in defects. First, each test piece was immersed in an aqueous copper sulfate solution, then air dried and subsequently heat treated in a nitrogen atmosphere at 900°C for about 20 minutes. Next, to remove the copper silicide layer at the surface of the test piece, the test piece was immersed in a HF/HNO₃ mixed solution and several tens of microns of material at the surface layer was etched away. The position of the OSF ring and the distribution of the various defect regions were then examined by x-ray topography.

By the doping of hydrogen each region corresponding to FIG. 9 and pulling rates for the region are changed as shown in FIG. 7 and Table 1. The pulling rate margins at the respective defect regions in Table I were determined by measuring the width of each defect region as seen in the axial direction at the center of the crystal.

Table 1

| | Hydrogen concentration | Pressure in furnace | Pulling rate margin (mm/min) in each region | | |
|---|---|---|---|---|---|
| | | | PI region | PV region | R-OSF region |
| Non-doped | -- | 30 torr | 0.009 | 0.005 | 0.024 |
| Hydrogen-doped | 6% | 30 torr | 0.040 | 0.006 | 0.018 |
| | 6% | 70 torr | 0.063 | 0.006 | 0.020 |

From the results shown in FIG. 7 and Table 1, the following are understood. The pulling rate margin for the PV region and the ring-like OSF region did not show large change by hydrogen doping. However, compared to pulling without hydrogen doping, the pulling rate margin in the PI region increased about 4.4-fold at an atmospheric pressure of 30 torr within the furnace and increased about 7-fold at an atmospheric pressure of 70 torr within the furnace when the crystal was pulled with hydrogen doping. This shows that the width of the PI region clearly increases in a manner dependent on the hydrogen partial pressure.

Examples

Examples of the invention are explained in the following.

Example 1

To examine the anti-slip properties during high temperature heat treatment, the three types of heat treatment processes shown in Table 2 were performed to silicon wafers sliced from a silicon single crystal grown at a constant pulling rate of 0.7 mm/min in an atmosphere having a hydrogen concentration of 6%. The heat-treated silicon wafers were evaluation by x-ray topographic (XRT). Based on the photographs obtained, the slip lengths from boat marks on the wafer caused by supporting boat were compared for each wafers. Table 2 shows the results for dependency of wafer strength on the heat treatment process.
Heat treatment in each case was carried out in an argon atmosphere.

Table 2

| Level | Heat treatment | Slip length ratio |
|---|---|---|
| 1 | DK treatment (650°C × 30 min) → Annealing (1200°C × hour) | 1 |
| 2 | Ramping Heat Treatment 1 → DK Treatment (650°C × 30 min) → Annealing (1200°C × 1 hour) | 0.5 |
| 3 | Ramping Heat Treatment 2 → DK Treatment (650°C × 30 min) → Annealing ( 1200°C × 1 hour) | <0.1 |

"Ramping Heat Treatment 1" in Table 2 is heat treatment at a ramping rate of 2.5°C/min from 500 to 650°C, and "Ramping Heat Treatment 2" is heat treatment at a ramping rate of 0.3°C/min from 500 to 650°C.
It is apparent from the above results that when Ramping Heat Treatment 2 is performed, slip dislocations from boat marks are substantially inhibited.
In addition, the high temperature annealed wafers (Levels 1 to 3) were subjected to additional heat treatment in an oxygen atmosphere at 1000°C for 16 hours, following which the bulk microdefects (BMDs) were developed and visualized by etching and the number of BMDs was counted. These results and the difference in oxygen concentration ($\Delta Oi$) before and after heat treatment are shown in Table 3 as the BMD density/$\Delta Oi$ dependence of the wafer strength.

Table 3

| Level | BMD density (/cm$^3$) | $\Delta Oi$ (atoms/cm$^3$) |
|---|---|---|
| 1 | $1.0 \times 10^9$ | 1.0 |
| 2 | $5.0 \times 10^9$ | 1.3 |

(continued)

| Level | BMD density (/cm³) | ΔOi (atoms/cm³) |
|-------|--------------------|-----------------|
| 3 | $1.5 \times 10^{10}$ | 1.5 |

The above results confirmed that a BMD density of not less than $1.0 \times (10^{10}/cm^3$ and a ΔOi before and after heat treatment of not less than $1.5 \times 10^{17}$ atoms/cm³ was required to suppress slip during heat treatment.

Wafers were sliced from a hydrogen-doped crystal having a full length of 800 mm and grown at a constant pulling rate of 0.7 mm/min in an atmosphere having a hydrogen concentration of 6%, and the resistivities at various positions along the crystal were measured by the four-point probe test. The wafers were then subjected to 30 minutes of heat treatment at 650°C as donor killer (DK) treatment to extinguish thermal donors, following which the resistivities of the wafer were measured once again.

FIG. 13 shows the impurity concentrations (thermal donor densities) calculated from the change in resistivity before and after DK treatment at various positions along the crystal. For the sake of reference, impurity concentrations for the case in which hydrogen was not supplied (non-doped) are also shown.

From the results in the diagram, it is apparent that the impurity concentration (thermal donor density) can be increased by carrying out the hydrogen doping. Hence, as shown in Table 2, it was found that slip propagation can be suppressed by one hour of annealing at 1200°C.

Example 2

Next, to examine the anti-slip properties due to the hydrogen concentration (vol%) in the inert gas atmosphere, silicon single crystal ingots were grown at a constant pulling rate of 0.7 mm/min and in an inert gas atmosphere having a hydrogen concentration (vol%) at one of six levels: 0. 1%, 3%, 6%, 10%, 20% and 0%. Silicon wafers sliced from each of the ingots were then prepared. Low temperature ramping heat treatment from 500 to 650°C was performed to each of the silicon wafers at a ramping rate of 0.3°C/min, following which 30 minutes of DK treatment at 650°C and one hour of high temperature heat treatment at 1200°C were performed. The heat-treated silicon wafers were subjected to x-ray topographic (XRT) evaluation and, based on the photographs obtained, the slip lengths from marks on the wafer supporting boats were compared. The results are shown in Table 4. Heat treatment in each case was carried out in an argon atmosphere.

Table 4

| Level | Hydrogen concentration (vol%) | Slip length ratio |
|-------|-------------------------------|-------------------|
| 1 (Example according to invention) | 0.1 | 1 |
| 2 (Example according to invention) | 3 | 0.5 |
| 3 (Example according to invention) | 6 | <0.1 |
| 4 (Example according to invention) | 10 | <0.1 |
| 5 (Example according to invention) | 20 | <0.1 |
| 6 (Comparative example) | 0 | 10 |

As is apparent from Table 4, the silicon wafers in the examples according to the invention (Levels 1 to 5) were able to suppress slip propagation much better than silicon wafers in the Comparative Example (Level 6). In particular, when the hydrogen concentration in the inert gas atmosphere was 3% or more, it was possible to suppress the slip propagation to an invisible level.

INDUSTRIAL APPLICABILITY

According to the present invention, by growing a silicon single crystal ingot in an inert gas atmosphere which includes a gaseous substance containing hydrogen atoms, it is possible to obtain a silicon single crystal ingot that contains, in the as-grown state, thermal donors in a high density. When a wafer is sliced from such a crystal and subjected to low temperature heat treatment, small-size oxide precipitates can be formed to a high density. During subsequent high temperature heat treatment at 1000°C or above by a method such as the DZ-IG method, the precipitates suppress slip propagation, preventing a reduction of wafer strength. The invention can thus provide silicon wafers of excellent strength having DZ layer which is essential for device formation. In the silicon wafers of the invention, the entire region of the wafer is composed solely of an interstitial silicon-rich region. Hence, it is possible to obtain wafers in which the density and size of oxide precipitates and the DZ width are extremely homogeneous throughout the wafer plane.

Moreover, in the present invention, by combining hydrogen doping with the growth conditions of the grown-in defect-free crystal, it is possible to expand the pulling rate range for achieving a defect-free state. Therefore, the invention enables the stable growth of defect-free crystals, and remarkably improves the production yield of grown-in defect-free crystals.

**Claims**

1. A method for producing a silicon wafer, comprising:

   growing a silicon single crystal by the Czochralski method in an inert atmosphere which includes a gaseous substance containing hydrogen atoms;
   slicing a wafer from the silicon single crystal;
   performing a high temperature heat treatment of the wafer in a non-oxidizing atmosphere at a temperature of not lower than 1000°C but not higher than 1300°C; and
   prior to the high temperature heat treatment, performing a low temperature heat treatment of the wafer at a temperature lower than the temperature used in the high temperature heat treatment.

2. A method for producing a silicon wafer, comprising:

   growing a silicon single crystal by the Czochralski method in an inert atmosphere which includes a gaseous substance containing hydrogen atoms;
   slicing a wafer from the silicon single crystal;
   performing a donor killer heat treatment of the wafer to prevent fluctuation of resistivity in the wafer; and
   prior to the donor killer heat treatment, performing a low temperature heat treatment of the wafer at a temperature lower than a temperature used in the donor killer heat treatment.

3. A method for producing a silicon wafer according to claim 1 or 2, wherein the temperature in the low temperature heat treatment is not lower than 400°C but not higher than 650°C, and the temperature is increased at a rate of not lower than 0.2°C/min but not higher than 2.0°C/min.

4. A method for producing a silicon wafer according to claim 3, wherein the low temperature heat treatment is carried out by ramping heat treatment.

5. A method for producing a silicon wafer according to claim 1, wherein the low temperature heat treatment is used to control a difference in an oxygen concentration before and after the high temperature heat treatment, based on a value measured in accordance with ASTM-F121 1979, to be not less than $1.5 \times 10^{17}$ atoms/cm$^3$.

6. A method for producing a silicon wafer according to claim 1, wherein the hydrogen concentration in the inert atmosphere at an atmospheric pressure of 1.3 to 13.3 kPa within the furnace is not less than 0.1% by volume but not more than 20% by volume.

7. A method for producing a silicon wafer according to clam 1 or 2, wherein the oxide precipitate density after the high temperature heat treatment is not less than $1.0 \times 10^{10}$ nuclei/cm$^3$.

8. A silicon wafer produced by the method according to claim 1 or 2.

# FIG. 1

BB

$10^9$

SIZE OF OXIDE
PRECIPITATION NUCLEI

DENSITY OF OXIDE PRECIPITATION NUCLEI

CRITICAL SIZE AT 900°C
WITHOUT LOW TEMPERATURE
RAMPING TREATMENT

# FIG. 2

CRITICAL SIZE AT 900°C
TREATED WITH LOW TEMPERATURE
RAMPING TREATMENT

# FIG. 3

INFRARED SCATTERING
DEFECT-DEVELOPING
REGION

DEFECT-FREE
REGION

RING-LIKE OSF
DEVELOPING REGION

OXIDE PRECIPITATION
PROMOTING REGION

OXIDE PRECIPITATION
INHIBITING REGION

DISLOCATION CLUSTER
DEVELOPING REGION

V

LOW

B

E

C

# FIG. 4

INFRARED SCATTERING
DEFECT DEVELOPING
REGION

DEFECT-FREE
REGION

RING-LIKE OSF
DEVELOPING REGION

OXIDE PRECIPITATION
PROMOTING REGION

OXIDE PRECIPITATION
INHIBITING REGION

DISLOCATION CLUSTER
DEVELOPING REGION

# FIG. 5

FIG. 6

# FIG. 7

| | |
|---|---|
| COP | COP |
| OSF | |
| PV | OSF |
| PI | PI |
| DISLOCATION | DISLOCATION |
| HYDROGEN-DOPED | NON-DOPED |

fp (mm/min)

# FIG. 8

FIG. 9

# FIG. 10

PULLING RATE

HYDROGEN-DOPED

WITHOUT
HYDROGEN DOPING

POSITION ON CRYSTAL

# FIG. 11

FIG. 12A

FIG. 12B

FIG. 12C

EP 1 909 315 A1

# FIG. 13

| | | |
|---|---|---|
| **INTERNATIONAL SEARCH REPORT** | International application No. | |
| | PCT/JP2005/020548 | |

A. CLASSIFICATION OF SUBJECT MATTER
*H01L21/322*(2006.01), *H01L21/324*(2006.01), *H01L21/26*(2006.01), *C30B29/06*
(2006.01), *C30B33/02*(2006.01)

According to International Patent Classification (IPC) or to both national classification and IPC

B. FIELDS SEARCHED

Minimum documentation searched (classification system followed by classification symbols)
C30B29/06, C30B33/02, H01L21/26, H01L21/322, H01L21/324

Documentation searched other than minimum documentation to the extent that such documents are included in the fields searched
Jitsuyo Shinan Koho       1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-281491 A  (Nippon Steel Corp.), 10 October, 2000 (10.10.00), Full text (Family: none) | 1-8 |
| Y | JP 2004-134439 A  (Shin-Etsu Handotai Co., Ltd.), 30 April, 2004 (30.04.04), Full text; Figs. 1 to 10 & WO 2004/034457 A1    & EP 1551058 A1 | 1-8 |
| Y | JP 04-298042 A  (Komatsu Electronic Metals Co., Ltd.), 21 October, 1992 (21.10.92), Full text; Figs. 1 to 11 (Family: none) | 2-4,7,8 |

☒ Further documents are listed in the continuation of Box C.       ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| | |
|---|---|
| Date of the actual completion of the international search | Date of mailing of the international search report |
| 03 February, 2006 (03.02.06) | 14 February, 2006 (14.02.06) |
| Name and mailing address of the ISA/ | Authorized officer |
| Japanese Patent Office | |
| Facsimile No. | Telephone No. |

Form PCT/ISA/210 (second sheet) (April 2005)

**INTERNATIONAL SEARCH REPORT**

International application No.

PCT/JP2005/020548

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2004-111722 A  (Toshiba Corp.),<br>08 April, 2004 (08.04.04),<br>Full text; Figs. 1 to 18<br>& US 2004/0056314 A1 | 5 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005217647 A
- JP 2002134521 A

- JP H111393 B

**Non-patent literature cited in the description**

- **M. SUEZAWA.** *The Division of Crystal Science and Technology, The Japan Society of Applied Physics,* 03 June 1999, 11
- **E. LINO ; K. TAKANO ; M. KIMURA ; H. YAMAGI-SHI.** *Material Science and Engineering,* 1996, vol. B36, 146-149

- **T.H. WANG ; T.F. CISZEK ; T. SCHUYLER.** *J. Cryst. Growth,* 1991, vol. 109, 155-161
- **Y. SUGITA.** *Jpn. J. Appl. Phys.,* 1965, vol. 4, 962